(19) **Europäisches Patentamt**
**European Patent Office**
**Office européen des brevets**

(11) Veröffentlichungsnummer : **0 297 027 B1**

(12) # EUROPÄISCHE PATENTSCHRIFT

(45) Veröffentlichungstag der Patentschrift :
07.08.91 Patentblatt 91/32

(51) Int. Cl.⁵ : **B32B 17/10, H05K 3/46,**
**B29C 43/12**

(21) Anmeldenummer : **88810237.3**

(22) Anmeldetag : **13.04.88**

(54) Vakuumpressverfahren und -vorrichtung zur Herstellung von Mehrlagenschaltungen.

(30) Priorität : 27.05.87 CH 2060/87

(43) Veröffentlichungstag der Anmeldung :
28.12.88 Patentblatt 88/52

(45) Bekanntmachung des Hinweises auf die
Patenterteilung :
07.08.91 Patentblatt 91/32

(84) Benannte Vertragsstaaten :
AT BE CH DE ES FR GB GR IT LI LU NL SE

(56) Entgegenhaltungen :
EP-A- 0 154 564
EP-A- 0 186 787
WO-A-85/05073
WO-A-87/05557
FR-A- 2 447 807
FR-A- 2 470 003
GB-A- 976 317
GB-A- 2 119 704

(56) Entgegenhaltungen :
CIRCUIT WORLD, Band 13, Nr. 2, 1987, Seiten
46-47; P.E. HINTON: "Pressing flex and rigidflex in a vacuum press"
ELEKTRONIK, Band 16, Nr. 9, September 1967,
Seiten 263-267, Franzis Verlag, München, DE;
J. KRAEMER: "Die Technik der Mehrlagenschaltung"
HYDRAULICS & PNEUMATICS, Band 39, Nr. 6,
Juni 1986, Seiten 31-33, Cleveland, Ohio, US;
S. NILSSON: "High-pressure press needs only one tool"

(73) Patentinhaber : FELA PLANUNGS AG
Täfernstrasse 11
CH-5405 Baden-Dättwil (CH)

(72) Erfinder : Uhlmann, Hans
Dorfstrasse 381
CH-5512 Wohlenschwil-Büblikon (CH)
Erfinder : Zuest, Harry Dr. sc.
Weinbergstrasse 58
CH-8703 Erlenbach (CH)

(74) Vertreter : Frauenknecht, Alois J. et al
c/o PPS Polyvalent Patent Service AG,
Mellingerstrasse 1
CH-5400 Baden (CH)

## Beschreibung

Die vorliegende Erfindung bezieht sich auf ein Vakuumpressverfahren zur Herstellung von Mehrlagenschaltungen, wobei mehrere Schaltungsplatten in einem verschlossenen Beutel gelagert werden, aus welchem das Gas evakuiert wird und wobei danach der Beutel mit den Schaltungsplatten mit Druck und erhöhter Temperatur von aussen beansprucht wird, bis die Schaltungsplatten zusammengepresst ausgehärtet werden, und auf eine Vorrichtung zur Durchführung des Verfahrens.

Ein Verfahren und eine Vorrichtung der genannten Art ist bekannt und zum Beispiel in der Publikation "Pressing Flex and Rigidflex in a Vacuum Press" von P.E. Hinton enthalten, die im April 1986 in Boston USA während des IPC 29th Annual Meetings veröffentlicht wurde. In dieser Veröffentlichung sind im wesentlichen drei verschiedene Arten enthalten. Gemäss einer Lösung befindet sich ein Stapel von Schaltungsplatten unter einer Verpackung auf einer Aluminiumplatte. Das Innere der Verpackung mit den Platten wird evakuiert und das Ganze ist in einem Druckbehälter befestigt. In diesen Druckbehälter wird Kohlendioxid mit steigendem Druck und steigender Temperatur gepumpt, wobei die Zirkulation des Gases im Inneren des Druckgefässes gesichert ist. Die Schaltungsplatten werden zusammengedrückt und dabei erhitzt und ausgehärtet. Eine andere Lösung verwendet zur Gewinnung des Druckes und der Wärme zwei Platten, die mit Presskolben einer hydraulischen Presse verbunden sind. Zwischen diesen Platten befindet sich der Stapel der Schaltungsplatten, der mit einem Beutel umhüllt ist. Das Innere des Beutels wird evakuiert. Die Platten der Presse sind geheizt, womit zusätzlich zum Druck auch die notwendige Wärme auf den Stapel der Schaltungsplatten übertragen wird. Die dritte Lösung entspricht teilweise der zweiten. Der Stapel der Schaltungsplatten befindet sich wieder zwischen beheizten Platten einer hydraulischen Presse. Das Ganze inkl. der Platten der Presse ist in einem Druckbehälter angeordnet, durch dessen Wände die Druckstangen der Presse abgedichtet geführt sind und der ganze Innenraum des Druckbehälters wird evakuiert. Diese Lösungen sind zwar verwendbar, weisen jedoch verschiedene Nachteile auf. Bei der ersten Lösung mit Kohlendioxid erfolgt die Wärmeübertragung mittels des Gases zufolge der geringen Wärmekapazität sehr langsam. Die zwei weiteren Lösungen haben den Nachteil, dass die beheizten Platten der hydraulischen Presse nur die oberste und unterste Schaltungsplatte des Stapels direkt beheizen und die Wärme aus diesen Schaltungsplatten in die weiteren Schaltungsplatten geführt werden muss mit der daraus resultierenden Retardierung des Wärmeflusses nach innen. Bei der dritten Lösung kommt noch dazu, dass man den ganzen Druckbehälter, also einen grossen Raum, evakuieren muss.

Die Aufgabe der vorliegenden Erfindung ist darin zu sehen, ein Vakuumpressverfahren und eine Vorrichtung zur Durchführung des Verfahrens zu schaffen, welche die obenerwähnten Nachteile des Bekannten nicht aufweist und welche schnell und ökonomisch unter Verwendung von möglichst kleinen Wärmemengen und unter Evakuierung von kleinem Volumen eine Herstellung von Mehrlagenschaltungsplatten ermöglichen, welche keine eingeschlossenen Gasteile enthalten.

Die vorgenannte Aufgabe wird erfindungsgemäss dadurch gelöst, dass der Beutel mit wenigstens einem Stapel der Schaltungsplatten, der in einem Druckbehälter angeordnet ist, nach der Evakuierung von aussen mit Hydraulikflüssigkeit mit steigendem Druck und steigender Temperatur solange beansprucht wird, bis der Druck und die Temperatur ihre Nennwerte erreichen, dass danach während 30 bis 60 min die Schaltungsplatten mit konstantem Druck und konstanter Temperatur beansprucht werden, dass die Hydraulikflüssigkeit gekühlt wird, ihr Druck entlastet und dass nach dem Entleeren des Druckbehälters wobei die Hydraulikflüssigkeit in einen Hydraulikflüssigkeitsbehälter fliesst, die Mehrlagerschaltungsplatte aus dem Beutel herausgenommen wird. Diese Lösung ist sehr wirtschaftlich, weil man mit Hydraulikflüssigkeit sowohl den gewünschten Druck als auch die in diesem Fall in gewünschten Grenzen notwendige Temperatur auf den Stapel der Schaltungsplatten übertragen kann, wobei nur ein verhältnismässig kleines Volumen evakuiert werden muss.

Der Druck ist in weiten Grenzen variierbar, entsprechend den Anforderungen der zu verpressenden Basismaterialien, im Prinzip können beliebig hohe Drucke bei entsprechender Auslegung des Druckbehälters erreicht werden, im Normalfall dürften 25 bar ausreichen.

Die Temperatur der Hydraulikflüssigkeit kann im Druckbehälter zweckmässig bis zu 220°C gesteigert werden. Auch in diesem Fall wird die genaue Bearbeitungstemperatur und ihre Steigerung den an sich bekannten Eigenschaften des bearbeiteten Materials angepasst.

Nach einer vorteilhaften Weiterbildung der Erfindung wird die Hydraulikflüssigkeit im Druckbehälter mit elektrischen Heizkörpern beheizt. Der Vorteil ist darin zu sehen, dass die höheren Temperaturen nur innerhalb des Druckbehälters vorkommen und die Tauchpumpe bei Raumtemperatur arbeitet.

Den Beutel für die Herstellung von Mehrlagenschaltungsplatten kann an seinem oberen Rand zweckmässig zwischen einem Flansch der Seitenwände des Druckbehälters und zwischen der oberen Platte des Druckbehälters eingeklemmt werden. Bei entsprechender Gestaltung der Flanschfläche entsteht somit auch eine ausreichende Dichtung zwischen dem genannten Flansch und der oberen Platte.

Die Vorrichtung zur Durchführung des beschriebenen Verfahrens, enthaltend einen Druckbehälter, eine

EP 0 297 027 B1

Vakuumeinrichtung und Leitungen für die Zirkulation einer Hydraulikflüssigkeit, ist dadurch gekennzeichnet, dass für die Druckerhöhung der Hydraulikflüssigkeit ausserhalb des Beutels eine sich in einem Hydraulikflüssigkeitsbehälter befindende Tauchpumpe vorgesehen ist. Die Tauchpumpen dieser Art werden serienmässig in verschiedenen Grössen und Leistungen hergestellt. In bezug auf lange Erfahrungen mit der Konstruktion dieser Tauchpumpen ist ihre Funktionsweise praktisch wartungsfrei und sehr zuverlässig. Es können alle Arten von Hochdruckpumpen, wie Zahnradpumpen, Flügelzellenpumpen, Kolbenpumpen, zur Anwendung gelangen, da diese bei Raumtemperatur verwendet werden. Ein weiterer Vorteil der Lösung mit diesen Tauchpumpen ist darin zu sehen, dass nur für die Druckflüssigkeit eine massive geschlossene Leitung notwendig ist, wobei die übrigen Leitungen ohne grössere Belastung nur die abfliessende Hydraulikflüssigkeit führen.

Gemäss einer Weiterausbildung der Erfindung mündet in das Innere des Beutels wenigstens eine Vakuumleitung. Diese Lösung ermöglicht, das notwendige Vakuum bei den im befestigten Beutel gelagerten Schaltungsplatten zu erreichen.

Um die Temperatur der Hydraulikflüssigkeit programmgemäss erhöhen zu können, sind im Inneren des Druckbehälters elektrische Heizkörper angeordnet. Es können in an sich bekannter Weise mehrere parallelgeschaltete Leitungen hergestellt werden, es kann auch eine einzige Leitung meanderartig geführt werden. Die Heizkörper bestehen aus Stahlrohren, in welchen in einer Keramik der Widerstandsheizdraht gerade oder spiralförmig gelagert ist.

Um mit der Vorrichtung schnell arbeiten zu können, ist es vorteilhaft, wenn im Inneren des Druckbehälters Kühlmediumleitungen angeordnet sind. Somit wird schnell die Temperatur der Hydraulikflüssigkeit gesenkt und danach das Verfahren beendet, ohne auf das normale Abkühlen der Hydraulikflüssigkeit warten zu müssen. Die Kühlmediumleitungen bestehen vorteilhaft aus Stahl, sind in einem oder mehreren Zweigen meanderartig geführt und werden zum Beispiel mit Wasserleitungswasser im offenen Kreislauf durchflossen. Weil zur Kühlung von etwa 30 Litern der sich im Druckbehälter befindenden Hydraulikflüssigkeit verhältnismässig wenig Kühlwasser gebraucht wird, wäre es unwirtschaftlich, die Kühlung in einem geschlossenen Kreis mit Wärmeaustauscher zu realisieren.

Zweckmässig ist die Hydraulikflüssigkeit durch Siliconöl oder fluorierte Kohlenwasserstoffe gebildet, die hervorragende Eigenschaften sowohl als Wärmeträger als auch als Druckflüssigkeit aufweisen. Zudem sind sie inert gegenüber den für die Beutel verwendeten Materialien.

Es ist vorteilhaft, wenn der Beutel aus Silikongummi, Vinylidenfluorid-Hexafluorpropylen-Copolymerisat (Du Pont : Viton®) oder Polyvinylidenfluorid besteht. Diese Materialien sind thermisch, chemisch und mechanisch für das erfindungsgemässe Vakuumpressen geeignet.

Die vorliegende Erfindung wird anhand einiger Zeichnungen näher erläutert. Gleiche Teile sind in allen Zeichnungen mit denselben Bezugsziffern versehen. Die Bestandteile, die zur Erklärung der Erfindungsidee nicht notwendig sind, wie zum Beispiel Klammern oder Schrauben für die Befestigung der Platten mit dem Flansch, die mechanischen Versteifungen der Seitenwände und der Platten oder verschiedene Dichtungen, sind weggelassen worden.

Es zeigen :

Fig. 1    eine vereinfachte Darstellung des gesamten Schemas der erfindungsgemässen Vorrichtung,
Fig. 2    einen vereinfachten Schnitt senkrecht zu den Schaltungsplatten, wobei die Vorrichtung in diesem Fall durch die Hydraulikflüssigkeit beansprucht ist,
Fig. 3    eine Draufsicht auf die Bodenplatte, auf welcher verschiedene Konstruktionselemente der Vorrichtung dargestellt sind,
Fig. 4    den Schnitt IV-IV aus der Fig. 3 entlang der Vakuumleitung und der Schaltungsplatten,
Fig. 5    den Schnitt V-V aus der Fig. 3 im Bereich der meanderartig angeordneten Kühlmediumleitungen,
Fig. 6    den Schnitt VI-VI aus der Fig. 7, in der ein Querschnitt durch den Beutel gezeigt ist, und
Fig. 7    den Längsschnitt VII-VII aus der Fig. 6 durch den Beutel.

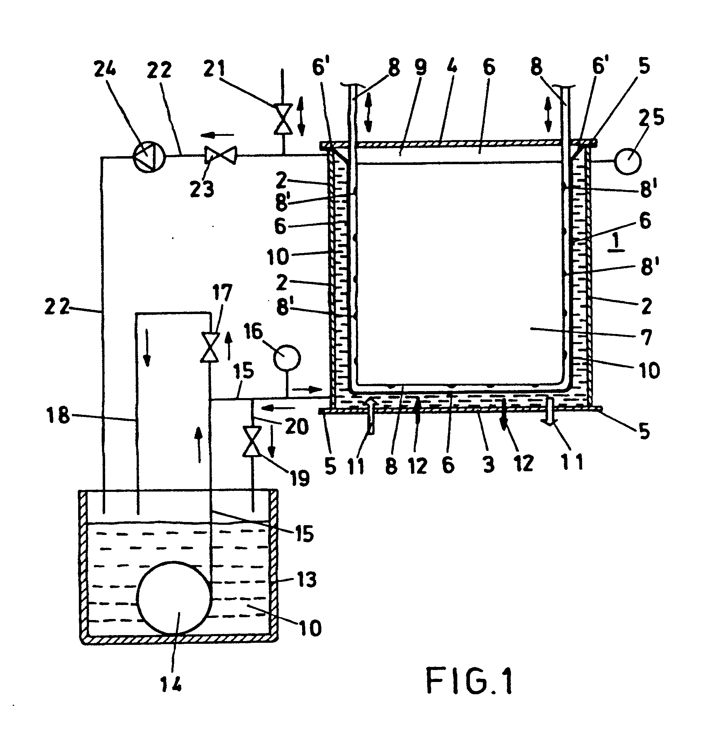

Gemäss Fig. 1 besteht ein Druckbehälter 1 aus vier Seitenwänden 2, einer Bodenplatte 3 und einer oberen Platte 4. Die Seitenwände 2 sind mit Flanschen 5 versehen, die zu der Befestigung der Bodenplatte 3 und der oberen Platte 4 dienen. Ein im Schnitt gezeichneter Beutel 6 (dicke Linie) ist mit Hilfe der Ränder 6' zwischen der oberen Platte 4 und dem zuständigen Flansch 5 eingeklemmt. In diesem Beutel sind ein oder mehrere Stapel von Schaltungsplatten 7 gelagert, aus welchen die Mehrlagenschaltungsplatte hergestellt werden soll. Eine Vakuumleitung 8 besteht aus einem Stahlrohr und ist in diesem Beispiel U-förmig ausgebildet. Die Vakuumleitung 8 ist mit kleinen Öffnungen 8' versehen, die zweckmässig in der Richtung zu den Schaltungsplatten 7 gerichtet sind. Auf diese Weise wird erreicht, dass die Schaltungsplatten 7 eigentlich mit drei Seiten des Umfangs die Vakuumleitung 8 berühren und somit den Beutel 6 eventuell mit scharfen Kanten nicht beschädigen können. Es ist selbstverständlich, dass die Vakuumleitung 8 mit mehreren kleinen Öffnungen 8' versehen

3

ist, um aus dem Beutel 6 die Luft oder ein anderes Gas evakuieren zu können. Die Vakuumleitung 8 kann selbstverständlich auch anders ausgebildet sein, es können zum Beispiel nur die vertikalen Teile ohne den unteren horizontalen Teil eingesetzt werden.

Vakuumräume sind mit der Bezugsziffer 9 bezeichnet und in diesem Bild sind diese praktisch nur im oberen Teil infolge der Befestigung der Ränder 6' des Beutels 6 und der oberen Platte 4 sichtbar. Zwischen den Seitenwänden 2 und der Bodenplatte 3 einerseits und dem Beutel 6 andererseits befindet sich die unter Druck stehende Hydraulikflüssigkeit 10. In der Bodenplatte 3 sind schematisch mit dicken Pfeilen Kühlmediumleitungen 11 und mit dünnen Pfeilen Stromleitungen 12 für elektrische Heizkörper dargestellt. Im linken unteren Teil der Fig. 1 ist ein Hydraulikflüssigkeitsbehälter 13 gezeigt, in welchem sich in der Hydraulikflüssigkeit 10 eine Tauchpumpe 14 befindet. Von dieser Tauchpumpe 14 führt eine Hydraulikflüssigkeitsleitung 15 in den Druckbehälter 1. Diese Hydraulikflüssigkeitsleitung 15 ist mit einem Hydraulikflüssigkeitsdruckmesser 16 versehen. Es ist selbstverständlich, dass die Hydraulikflüssigkeit 10 im Druckbehälter 1 während der Tätigkeit der Tauchpumpe 14 steigt und dass die oberhalb der Hydraulikflüssigkeit 10 sich befindende Luft den Druckbehälter 1 verlassen muss. Dies geschieht durch ein Entlüftungsventil 21, das umgekehrt beim Entleeren der Hydraulikflüssigkeit 10 aus dem Druckbehälter 1 die Funktion eines Belüftungsventils übernimmt. Die Hydraulikflüssigkeit 10 steigt im Druckbehälter 1 bis zu der Überlaufleitung 22, durch die sie abfliessen kann, soweit das Absperrventil 23 offen ist. Dieses wird jedoch nach dem Einfüllen des Druckbehälters 1 mit der Hydraulikflüssigkeit 10 gesperrt, so dass eine Strömungsanzeige 24 keinen Durchfluss signalisiert und durch die Überlaufleitung 22 keine Hydraulikflüssigkeit zurück in den Hydraulikflüssigkeitsbehälter 13 fliesst. Um den Druck im Druckbehälter 1 zu erhöhen, wird ein Regulierventil 17 geschlossen. Beim geöffneten Regulierventil 17 kann die Hydraulikflüssigkeit 10 durch den Abfluss 18 zurück in den Hydraulikflüssigkeitsbehälter 13 fliessen. Der Druck der Hydraulikflüssigkeit wird mit dem schon erwähnten Hydraulikflüssigkeitsdruckmesser 16 signalisiert. Nach dem Einfüllen des Druckbehälters 1 und nach wenigstens teilweiser Steigerung des Druckes der Hydraulikflüssigkeit 10 wird mit Hilfe von Stromleitungen 12 die elektrische Heizung der Hydraulikflüssigkeit 10 eingeschaltet. Die steigende Temperatur der Hydraulikflüssigkeit 10 wird mit einem Thermometer 25 gemessen. Nach dem Erreichen der gewünschten Temperatur und nach dem Aushärten der Mehrlagenschaltungsplatte 7 wird die Hydraulikflüssigkeit mit Hilfe von Kühlmediumleitungen 11 gekühlt, der Hydraulikflüssigkeitsdruck wird entlastet und die Hydraulikflüssigkeit kann über ein Ventil 19 durch die Leitung 20 wieder in den Hydraulikflüssigkeitsbehälter 13 fliessen. Der Hydraulikflüssigkeitskreislauf ist geschlossen und es können praktisch keine Hydraulikflüssigkeitsverluste vorkommen.

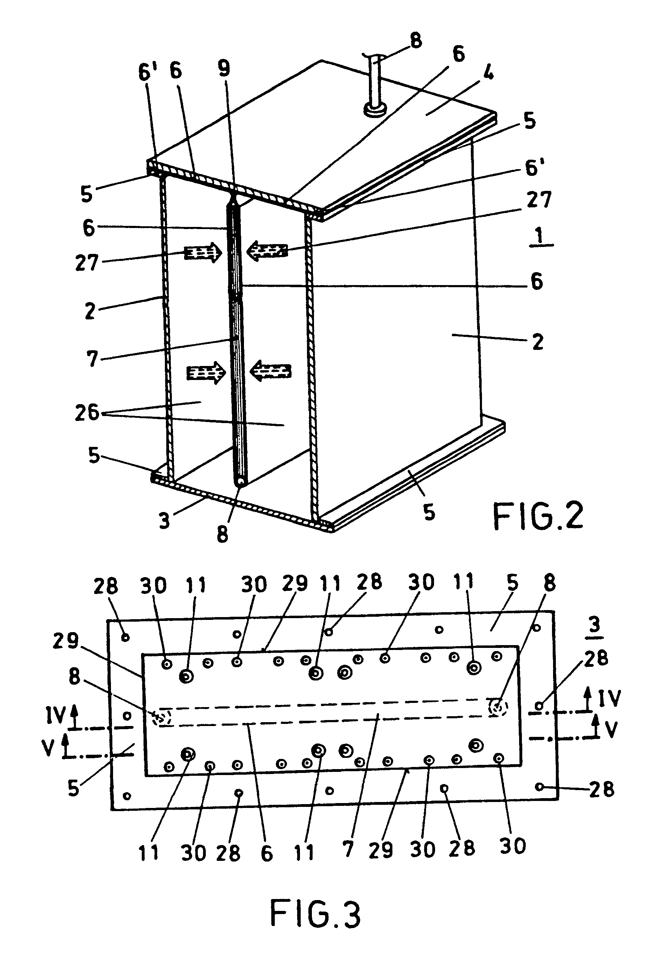

In der Fig. 2 ist ein Schnitt durch die erfindungsgemässe Vorrichtung senkrecht zu der in der Fig. 1 gezeigten Lage dargestellt. Wie schon erwähnt, sind die schon beschriebenen Teile mit denselben Bezugsziffern versehen. In Fig. 2 ist der innere Raum als Druckraum 26 bezeichnet, wobei die dicken Pfeile 27 die Hauptdruckrichtungen auf die Mehrlagenschaltungsplatte 7 zeigen. Es ist selbstverständlich, dass der Hydraulikflüssigkeitsdruck in alle Richtungen wirkt. Aus diesem Grunde wird entweder der Druckbehälter 1 massiv hergestellt oder zusätzlich zum Beispiel mit Verstärkungsrippen in an sich bekannter Weise versehen. Aus der Fig. 2 ist gut sichtbar, dass die seitlichen Teile des Beutels 6 auf die Mehrlagenschaltungsplatte 7 gedrückt sind, was auch den vertikalen Teil der Vakuumleitung 8 betrifft. Im oberen Teil ist der Beutel 6 zusammengepresst und in den weiteren Teilen auf die untere Fläche der oberen Platte 4 bis zu den Befestigungsstellen zwischen dieser Platte 4 und dem Flansch 5 gedrückt. Es entstehen nur kleine Vakuumräume 9 in den Fällen, wo die Elastizität des Beutels 6 nicht ausreicht, sich dem Hydraulikflüssigkeitsdruck anzupassen. Der Beutel 6 besteht zweckmässig aus Silikongummi, Vinylidenfluorid-Hexafluorpropylen-Copolymerisat (Du Pont : Viton®) oder Polyvinylidenfluorid. Es können selbstverständlich auch andere ähnliche Materialien, deren Plastizität und Festigkeit ausreichend sind, eingesetzt werden.

In der Fig. 3 ist eine Bodenplatte 3 gezeigt. Am Rande dieser Bodenplatte 3 ist der Flansch 5 dargestellt, der mit Befestigungsbohrungen 28 versehen ist. Mit einem Rechteck ist der Grundriss 29 der Seitenwände 2 gezeigt. Innerhalb dieser Seitenwände 2 befinden sich elektrische Heizkörper 30, die beidseitig der Schaltungsplatten 7 U-förmig oder meanderartig angeordnet und zur Beheizung der Hydraulikflüssigkeit 10 bestimmt sind. Ebenfalls sind die Kühlmediumleitungen 11 in den Stellen eingezeichnet, in welchen sie durch die Bodenplatte 3 geführt sind. Die Vakuumleitung 8, die sich im Beutel 6 befindet, und innerhalb deren die Schaltungsplatten 7 gelagert sind, berührt die Bodenplatte 3 nicht, darum ist sie wegen der Anschaulichkeit nur gestrichelt eingezeichnet.

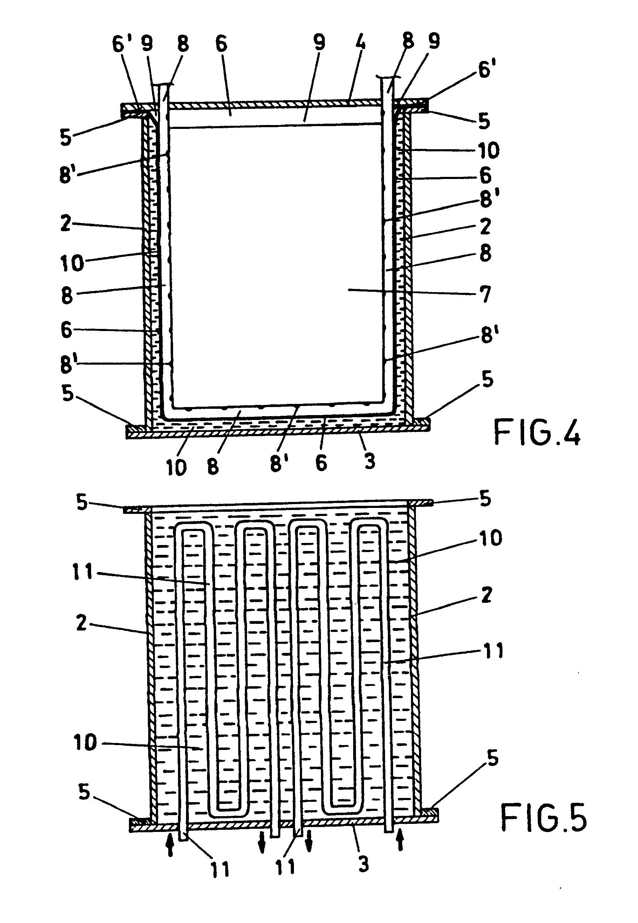

Die Fig. 4 zeigt den Schnitt IV-IV aus der Fig. 3. Dieser Schnitt verläuft entlang der Vakuumleitung 8 und der Schaltungsplatten 7. Der Druckbehälter 1 ist in diesem Fall mit unter Druck stehender Hydraulikflüssigkeit 10 gefüllt, so dass der Beutel 6 an die Vakuumleitung 8 anliegt. In der Vakuumleitung 8 sind mehrere kleine Öffnungen 8' eingezeichnet, die die Evakuierung und danach wieder die Belüftung des Inneren des Beutels 6 ermöglichen. Der Beutel 6 ist in seinem oberen Rand 6' zwischen den Flansch 5 und die obere Platte 4 eingeklemmt, wobei dieser Rand 6' massiver ausgebildet wird, weil er gleichzeitig als Flanschdichtung dient. Ober-

4

halb der Schaltungsplatten 7 ist der Beutel 6 teilweise durch den äusseren Druck der Hydraulikflüssigkeit 10 zusammengepresst, wobei in den Biegungsstellen des Beutels 6 ein Vakuumraum 9 entsteht. Ähnliche Vakuumräume 9 bilden sich in der Nähe der Befestigung des Flansches 5.

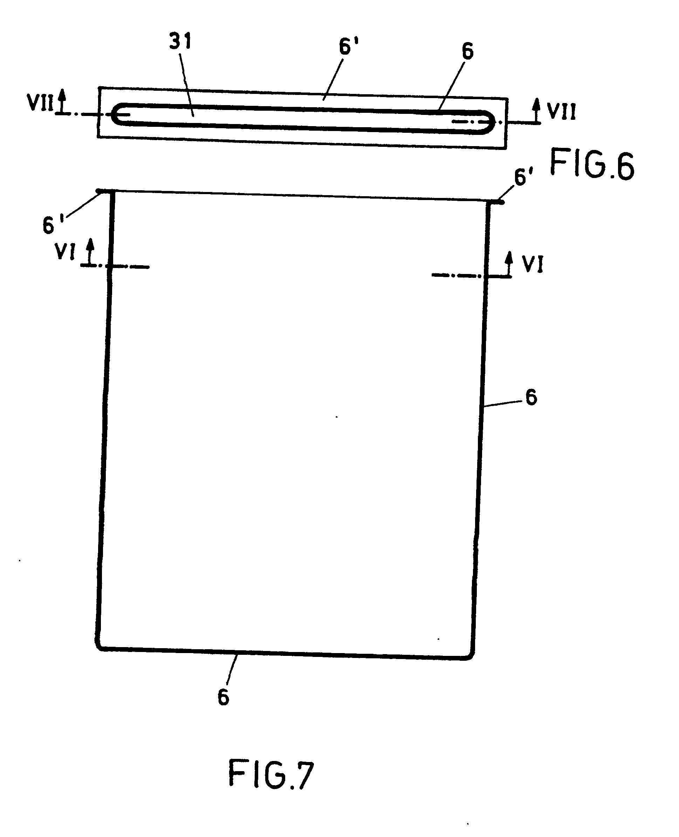

In der Fig. 5 ist der Schnitt V-V aus der Zeichnung 3 dargestellt. In diesem Fall ist die Kühlmediumleitung 11 als zwei meanderartige Einheiten ausgebildet, die mit Kühlwasser durchflossen sind. Auf diese Art kann man sehr schnell die erhöhte Temperatur der Hydraulikflüssigkeit 10 wieder in Bereich der Zimmertemperatur bringen.

Auf ähnliche Art sind auch die elektrischen Heizkörper 30 ausgebildet, deren Ausführungsform schon früher beschrieben wurde.

Die Fig. 6 und Fig. 7 zeigen zwei gegenseitig senkrechte Schnitte durch einen Beutel 6. In der Fig. 6 ist der Schnitt VI-VI aus der Fig. 7 gezeigt. In dieser Fig. 6 ist die Form der Ränder 6' des Beutels 6 veranschaulicht, wobei im Inneren ein Raum 31 für die Schaltungsplatten 7 vorgesehen ist. Der Schnitt VII-VII aus der Fig. 6 ist in der Fig. 7 dargestellt.

Auch in diesem Fall ist ersichtlich, dass der Beutel 6 im wesentlichen als ein hohles Rechteck ausgebildet ist, was der Form der Schaltungsplatten 7 entspricht. Auch in der Fig. 7 ist der zur Befestigung bestimmte Rand 6' gezeigt.

Die Funktionsweise des Erfindungsgegenstandes wurde praktisch schon anhand der Ansprüche und der Zeichnungen beschrieben. Übersichtlich sind folgende Stufen der Herstellung von Mehrlagenschaltungsplatten 7 beschrieben :

1) In den Beutel 6 wird wenigstens ein Stapel der Schaltungsplatten 7 eingelegt. Die Vakuumleitungen 8 können sowohl vorher als auch nachher in den Beutel 6 eingeschoben werden.

2) Die obere Platte 4 wird auf den Flansch 5 aufgesetzt, wobei der Rand 6' des Beutels zwischen diese Teile eingeklemmt wird. Der Flansch 5 wird mit der oberen Platte 4 zusammengebunden, zum Beispiel mit Hilfe von Klammern oder Schrauben.

3) Mit Hilfe der Vakuumleitung 8 und einer an sich bekannten nicht dargestellten Vakuumpumpe wird innerhalb des Beutels 6 ein Vakuum (zum Beispiel 1 mbar) während einer bestimmten Zeit (zum Beispiel 5 min) erreicht.

4) Der Druckbehälter 1 wird mit Hilfe der Tauchpumpe 14 mit der Hydraulikflüssigkeit 10 gefüllt.

5) Die Hydraulikflüssigkeit 10 wird unter Druck gesetzt, wobei der Druck zum Beispiel bis zu 25 bar gesteigert wird.

6) Mit Hilfe von elektrischen Heizkörpern 30 wird die Temperatur der Hydraulikflüssigkeit 10 im Druckbehälter 1 bis zur Verpresstemperatur < 200°C und auf diesem Niveau 30 bis 60 min gehalten.

7) Mit Hilfe von Kühlmediumleitungen 11 wird danach die Hydraulikflüssigkeit 10 gekühlt. Die Praxis hat gezeigt, dass zu der Kühlung weniger als 10 min ausreichen.

8) Der Druck der Hydraulikflüssigkeit 10 wird bis zum atmosphärischen Druck entlastet.

9) Der Druckbehälter 1 wird mit Hilfe des Ventils 19 entleert, wobei die Hydraulikflüssigkeit 10 wieder in den Hydraulikflüssigkeitsbehälter 13 fliesst.

10) Die obere Platte 4 des Druckbehälters 1 wird abgenommen und aus dem Beutel 6 wird die fertige Mehrlagerschaltungsplatte 7 herausgenommen.

Bei einem Beispiel der Realisation des Erfindungsgegenstandes wurde ein Druckbehälter 1 mit innerem Volumen für etwa 30 Liter Hydraulikflüssigkeit 10 verwendet. Die Hydraulikflüssigkeit 10 wurde mit elektrischen Heizelementen mit gemeinsamer Leistung 12 kW beheizt. Die Leistung der Tauchpumpe 14 war 0,75 kW und die Pumpe hat etwa 10 Liter Hydraulikflüssigkeit pro min geliefert. Für die Kühlmediumleitungen 11 wurden Stahlrohre mit äusserem Durchmesser von 12 mm verwendet. Der äussere Durchmesser der Rohre der elektrischen Heizkörper 30 betrug 8,4 mm. Der Druckbehälter 1 wurde aus Stahlplatten mit der Dicke von 10 mm hergestellt, wobei seine Breite 560 mm und die Höhe 600 mm betrug. Der Flansch 5 wurde mit zehn Bohrungen mit Durchmesser von 10,5 mm versehen. Es ist selbstverständlich, dass sich entsprechende Bohrungen auch in den Platten 3, 4 befinden. Der Beutel 6 wurde mit der Wandstärke 2,5 mm hergestellt, wobei sein Rand 6' auf 3 mm Wandstärke verdickt wurde.

Es ist selbstverständlich, dass der Erfindungsgegenstand auf das in den Zeichnungen Dargestellte nicht beschränkt ist. So kann man zum Beispiel eine andere Art der Beheizung und der Kühlung der Hydraulikflüssigkeit 10 ansetzen, es kommt auch eine andere Ausbildung und Befestigung des Beutels 6 in Frage. Anstelle der Vakuumleitung 8, die in unserem Beispiel in einer U-Form gezeigt wurde, können entweder zwei vertikale, unten offene Vakuumleitungen verwendet werden, die sich seitlich der Schaltungsplatten 7 erstrecken, oder in einigen Fällen würden nur sehr kurze Vakuumleitungen 8 im oberen Bereich des Beutels 6 ausreichen. Es ist auch selbstverständlich, dass das Messen des Druckes und der Temperatur der Hydraulikflüssigkeit 10

EP 0 297 027 B1

anders realisiert werden kann, als gezeichnet.

**Patentansprüche**

1. Vakuumpressverfahren zur Herstellung von Mehrlagenschaltungen, wobei mehrere Schaltungsplatten (7) in einem verschlossenen Beutel (6) gelagert werden, aus welchem das Gas evakuiert wird und wobei danach der Beutel (6) mit den Schaltungsplatten (7) mit Druck und erhöhter Temperatur von aussen beansprucht wird, bis die Schaltungsplatten (7) zusammengepresst ausgehärtet werden, dadurch gekennzeichnet, dass der Beutel (6) mit wenigstens einem Stapel der Schaltungsplatten (7), der in einem Druckbehälter (1) angeordnet ist, nach der Evakuierung von aussen mit Hydraulikflüssigkeit (10) mit steigendem Druck und steigender Temperatur solange beansprucht wird, bis der Druck und die Temperatur ihre Nennwerte erreichen, dass danach während 30 bis 60 min die Schaltungsplatten (7) mit konstantem Druck und konstanter Temperatur beansprucht werden, dass die Hydraulikflüssigkeit gekühlt wird, ihr Druck entlastet und dass nach dem Entleeren des Druckbehälters, wobei die Hydraulikflüssigkeit in einen Hydraulikflüssigkeitsbehälter fliesst, (1) die Mehrlagenschaltungsplatte (7) aus dem Beutel (6) herausgenommen wird.

2. Verfahren nach Anspruch 1, dadurch gekennzeichnet, dass die Temperatur der Hydraulikflüssigkeit (10) im Druckbehälter (1) bis zu 220°C gesteigert wird.

3. Verfahren nach Anspruch 1, dadurch gekennzeichnet, dass das Hydraulikflüssigkeit (10) im Druckbehälter (1) mit elektrischen Heizkörpern (30) beheizt wird.

4. Verfahren nach Anspruch 1, dadurch gekennzeichnet, dass die Ränder (6') des Beutels (6) zwischen einem Flansch (5) der Seitenwände (2) des Druckbehälters (1) und zwischen einer oberen Platte (4) des Druckbehälters (1) eingeklemmt sind.

5. Vorrichtung zur Durchführung des Verfahrens nach Anspruch 1, enthaltend einen Druckbehälter, ein Vakuumeinrichtung und Leitungen für die Zirkulation einer Hydraulikflüssigkeit, dadurch gekennzeichnet, dass für die Druckerhöhung der Hydraulikflüssigkeit (10) ausserhalb des Beutels (6) eine sich in einem Hydraulikflüssigkeitsbehälter (13) befindende Tauchpumpe (14) vorgesehen ist.

6. Vorrichtung nach Anspruch 5, dadurch gekennzeichnet, dass in das Innere des Beutels (6) wenigstens eine Vakuumleitung (8) mündet.

7. Vorrichtung nach Anspruch 5, dadurch gekennzeichnet, dass im Inneren des Druckbehälters (1) elektrische Heizkörper (30) angeordnet sind.

8. Vorrichtung nach Anspruch 5, dadurch gekennzeichnet, dass im Inneren des Druckbehälters (1) Kühlmediumleitungen (11) angeordnet sind.

9. Vorrichtung nach Anspruch 5, dadurch gekennzeichnet, dass die Hydraulikflüssigkeit (10) durch Siliconöl oder fluorierte Kohlenwasserstoffe gebildet ist.

10. Vorrichtung nach Anspruch 5, dadurch gekennzeichnet, dass der Beutel (6) aus Silikongummi, Vinylidenfluorid-Hexafluorpropylen-Copolymerisat (Du Pont : Viton®) oder Polyvinylidenfluorid besteht.

**Claims**

1. A vacuum-press method for producing multiple-layer circuits, a plurality of circuit boards (7) being mounted in a closed bag (6), from which the gas is evacuated, and the bag (6) with the circuit boards (7) subsequently being subjected to pressure and increased temperature from the outside, until the circuit boards (7) are cured while pressed together, **characterized in that** the bag (6) with at least one stack of circuit boards (7) arranged in a pressure container (1) is acted upon after the evacuation from the outside with hydraulic liquid (10) with increasing pressure and increasing temperature until the pressure and the temperature reach their nominal values, the circuit boards (7) are then acted upon with constant pressure and constant temperature for 30 to 60 minutes, the hydraulic liquid is cooled, its pressure is released and after the evacuation of the pressure container (1) — the hydraulic liquid flowing into an hydraulic liquid container — the multiple-layer circuit board (7) is removed from the bag (6).

2. A method according to Claim 1, **characterized in that** the temperature of the hydraulic liquid (10) in the pressure container (1) is increased to 220°C.

3. A method according to Claim 1, **characterized in that** the hydraulic liquid (10) in the pressure container (1) is heated with electric heating elements (30).

4. A method according to Claim 1, **characterized in that** the edges (6') of the bag (6) are clamped between a flange (5) of the side walls (2) of the pressure container (1) and between an upper plate (4) of the pressure container (1).

6

5. Apparatus for performing the method according to Claim 1, comprising a pressure container, a vacuum device and lines for the circulation of an hydraulic liquid, **characterized in that** in order to increase the pressure of the hydraulic liquid (10) a submerged pump (14) disposed in an hydraulic liquid container (13) is provided outside the bag (6).

6. Apparatus according to Claim 5, **characterized in that** at least one vacuum line (8) opens into the interior of the bag (6).

7. Apparatus according to Claim 5, **characterized in that** electric heating elements (30) are disposed in the interior of the pressure container (1).

8. Apparatus according to Claim 5, **characterizd in that** coolant lines (11) are disposed in the interior of the pressure container (1).

9. Apparatus according to Claim 5, **characterized in that** the hydraulic liquid (10) is formed by silicone oil or fluorinated hydrocarbons.

10. Apparatus according to Claim 5, **characterized in that** the bag (6) consists of silicone rubber, vinylidene fluoride hexafluoropropylene copolymerizate (Du Pont : Viton®) or polyvinylidene fluoride.


## Revendications

1. Procédé de compression sous vide pour la fabrication de circuits imprimés multicouches, une pluralité de plaquettes à circuits imprimés (7) étant placées dans un sachet (6) fermé dans lequel on évacue le gaz, ledit sachet (6) avec les plaquettes à circuits imprimés (7) étant ensuite sollicité par l'extérieur en compression et soumis à une température accrue jusqu'au durcissement complet des plaquettes à circuits imprimés (7) comprimées **caractérisé en ce** que le sachet (6) contenant au moins une pile de plaquettes à circuits imprimés (7) et placé dans un réservoir sous pression (1) est soumis, après l'évacuation, à la pression et à la température croissantes d'un fluide hydraulique (10) appliquées par l'extérieur jusqu'à ce que la pression et la température atteignent leurs valeurs nominales ; que les plaquettes à circuits imprimés (7) sont ensuite soumises pendant 30 à 60 minutes à une pression et une température constantes ; que le fluide hydraulique est refroidi et sa pression diminuée ; et que la plaquette à circuits imprimés multi-couche (7) est retirée du sachet (6) après l'évacuation du réservoir sous pression (1) le fluide hydraulique s'écoulant dans un réservoir de fluide hydraulique.

2. Procédé selon la revendication 1, caractérisé en ce que la température du fluide hydraulique (10) dans le réservoir sous pression (1) est augmentée jusqu'à 220°C.

3. Procédé selon la revendication 1, caractérisé en ce que le fluide hydraulique (10) est chauffé dans le réservoir sous pression (1) au moyen de corps de chauffe électriques (30).

4. Procédé selon la revendication 1, caractérisé en ce que les bords (6') du sachet (6) sont enserrés entre une bride (5) des parois latérales (2) du réservoir sous pression (1) et une plaque supérieure (4) dudit réservoir sous pression (1).

5. Dispositif pour la mise en oeuvre du procédé selon la revendication 1, comprenant un réservoir sous pression, un dispositif pour faire le vide et des conduites pour la circulation du fluide hydraulique, **caractérisé en ce** que, pour l'augmentation de la pression du fluide hydraulique (10) une pompe noyée (14) est prévue, à l'extérieur du sachet (6), dans un réservoir de fluide hydraulique (13).

6. Dispositif selon la revendication 5, caractérisé en ce qu'au moins une conduite à vide (8) débouche à l'intérieur du sachet (6).

7. Dispositif selon la revendication 5, caractérisé en ce que des corps de chauffe électriques (30) sont disposés à l'intérieur du réservoir sous pression (1).

8. Dispositif selon la revendication 5, caractérisé en ce que des conduites de réfrigérant (11) sont disposées à l'intérieur du réservoir sous pression (1).

9. Dispositif selon la revendication 5, caractérisé en ce qu'il utilise comme fluide hydraulique (10) de l'huile silicone ou des hydrocarbures fluorés.

10. Dispositif selon la revendication 5, caractérisé en ce que le sachet (6) est réalisé en caoutchouc silicone, en copolymère de fluorure de vinylidène-hexafluorpropylène (Du Pont : Viton®) ou en fluorure de polyvinylidène.

FIG.1

FIG.2

FIG.3

FIG.4

FIG.5

FIG.6

FIG.7